Europäisches Patentamt

European Patent Office

Office européen des brevets

(19)

(11) Veröffentlichungsnummer: **0 370 186**
**A1**

## (12) EUROPÄISCHE PATENTANMELDUNG

(21) Anmeldenummer: **89116527.6**

(22) Anmeldetag: **07.09.89**

(51) Int. Cl.⁵: **H01L 21/263, H01L 21/22**

(30) Priorität: **19.11.88 DE 3839210**

(43) Veröffentlichungstag der Anmeldung:
**30.05.90 Patentblatt 90/22**

(84) Benannte Vertragsstaaten:
**AT BE CH DE FR GB IT LI NL**

(71) Anmelder: **ASEA BROWN BOVERI AG**
**Haselstrasse**
**CH-5401 Baden(CH)**

(72) Erfinder: **Beeler, Franz, Dr.**
**Pilgerstrasse 2**
**CH-5405 Baden(CH)**
Erfinder: **Halder, Erich, Dr.**
**Cholacherstrasse 6**
**CH-5452 Oberrohrdorf(CH)**
Erfinder: **Hüppi, Marcel, Dr.**
**Schrennengasse 11**
**CH-8003 Zürich(CH)**

(54) **Verfahren zum axialen Einstellen der Trägerlebensdauer.**

(57) Ein Verfahren zum axialen Einstellen der Trägerlebensdauer in einem Halbleiterbauelement mit einem kristallinen Halbleitersubstrat (1), umfasst folgende Schritte:

a) Eindiffundieren von Fremdatomen in das
Halbleitersubstrat, wobei die Fremdatome die Eigenschaft haben, dass sie (i) auf einem Gitterplatz rekombinationsaktiv und auf einem Zwischengitterplatz
rekombinationsinaktiv sind und dass sie (ii) interstitiell und via Leerstellen-Mechanismus, aber nicht via
Kick-out-Mechanismus diffundieren;

b) Bestrahlen des Halbleitersubstrats mit
hochenergetischen Teilchen (6), sodass in einer vorgegebenen Tiefe ein gewünschtes Konzentrationsprofil von Gitterstörstellen entsteht;

c) thermisches Aktivieren der eindiffundierten
Fremdatome.

FIG.1

EP 0 370 186 A1

## Verfahren zum axialen Einstellen der Trägerlebensdauer

### Technisches Gebiet

Die Erfindung betrifft ein Verfahren zum axialen Einstellen der Trägerlebensdauer in einem Halbleiterbauelement mit einem kristallinen Halbleitersubstrat.

### Stand der Technik

Leistungs-halbleiterbauelemente sollen einerseits eine möglichst kurze Schaltzeit (Uebergang vom Durchlass- in den Sperrzustand) und andrerseits möglichst geringe Schaltverluste (geringer Spannungsabfall im Durchlasszustand) aufweisen. Diese gegensätzlichen Forderungen können durch gezielte Einstellung der Ladungsträgerlebensdauer optimiert werden. Gegenwärtig werden dafür zwei grundsätzlich verschiedene Methoden eingesetzt.

Die eine ist die kontrollierte Eindiffusion von Fremdatomen, meist Uebergangsmetallen wie z.B. Au, Pt, etc. Die Rekombinationsspezies (Fremdatom) ist dabei wählbar, das resultierende Konzentrationsprofil dagegen ist im wesentlichen durch das Diffusionsverhalten der Fremdatome im Halbleiterkristall bestimmt.

Die andere Methode ist die Bestrahlung mittels hochenergetischer Partikel (Elektronen, Protonen, Helium etc.). Hier ist das Konzentrationsprofil relativ frei wählbar. Die dabei erzeugten Rekombinationszentren sind aber durch die Bestrahlung vorgegeben.

### Darstellung der Erfindung

Aufgabe der Erfindung ist es, ein Verfahren zum axialen Einstellen der Trägerlebensdauer in einem Halbleiterbauelement mit einem kristallinen Halbleitersubstrat zu schaffen, bei welchem sowohl die Rekombinationszentren als auch das dazugehörige Konzentrationsprofil relativ frei vorgegeben werden können.

Erfindungsgemäss besteht die Lösung darin, dass ein Verfahren der eingangs genannten Art folgende Schritte umfasst:

a) Eindiffundieren von Fremdatomen in das Halbleitersubstrat, wobei die Fremdatome die Eigenschaft haben, dass sie (i) auf einem Gitterplatz rekombinationsaktiv und auf einem Zwischengitterplatz rekombinationsinaktiv sind und dass sie (ii) interstitiell und via Leerstellen-Mechanismus, aber nicht via Kick-out-Mechanismus diffundieren

b) Bestrahlen des Halbleitersubstrats mit hochenergetischen Teilchen (6), sodass in einer vorgegebenen Tiefe ein gewünschtes Konzentrationsprofil von Gitterstörstellen entsteht;

c) thermisches Aktivieren der eindiffundierten Fremdatome.

Vorzugsweise werden als Fremdatome Cu-, Ag-, oder Pd-Atome und zum Bestrahlen He+, He++, Protonen oder Neutronen verwendet.

Weitere vorteilhafte Ausführungsformen der Erfindung ergeben sich aus den abhängigen Patentansprüchen.

### Kurze Beschreibung der Zeichnung

Nachfolgend soll die Erfindung anhand von Ausführungsbeispielen und im Zusammenhang mit der Zeichnung näher erläutert werden. Es zeigen:

Fig. 1a - 1f
eine Darstellung der wesentlichen Verfahrensschritte eines erfindungsgemässen Verfahrens.

### Wege zur Ausführung der Erfindung

Zum besseren Verständnis der Erfindung sollen zunächst einige zugrunde liegende Prinzipien diskutiert werden.

Voraussetzung für das erfindungsgemässe Verfahren sind Fremdatome mit folgenden Rekombinations- und Diffusionseigenschaften:

1. Rekombinationsaktiv auf einem Gitterplatz

2. Rekombinationsinaktiv auf einem Zwischengitterplatz (interstitiell).

3. Diffusion erfolgt interstitiell und via Leerstellenmechanismus (d.h. dissoziativ), aber im wesentlichen nicht via Kick-out-Mechanismus.

Welche Eigenschaften ein gegebenes Fremdatom in einem bestimmten Halbleiterkristall hat, lässt sich aufgrund energetischer Ueberlegungen eruieren.

Fremdatome mit diesen Eigenschaften in einem Siliziumkristall sind z.B. Cu-, Ag oder Pd-Atome. Ag hat gegenüber Cu den Vorteil, dass es nur eine geringe Tendenz zur Komplexbildung hat.

Ag hat ähnlich wie Au die Eigenschaft, auf dem substitutionellen Platz (Gitterplatz) in kristallinem Silizium als effektives Rekombinationszentrum zu wirken. Im Gegensatz zur Au-Diffusion beruht die Ag-Diffusion aber nicht auf dem (bei der axialen Trägerlebensdauereinstellung) unerwünschten Kick-out-Mechanismus, sondern erfolgt interstitiell und via Leerstellen-Mechanismus.

Interstitiell eingebaute Ag-Atome ergeben dabei keinen Beitrag zum rekombinations-relevanten Profil. Durch den Leerstellen-Mechanismus (dissoziativer Mechanismus, Diffusion via Leerstelle: Ag(int) + Vac --> Ag(sub) ) werden hingegen Ag-Rekombinationszentren erzeugt. Das Konzentrationsprofil von rekombinationsrelevantem Ag (substitutionelles Ag: Ag(sub) ) ist also mit dem Konzentrationsprofil der Leerstellen (Vacancy: Vac) korreliert.

Durch Bestrahlen mittels schwerer Teilchen (Protonen, Neutronen, Helium etc.) ist es möglich, an einer beliebig vorgegebenen Stelle im Halbleiterbauelement Leerstellen und Doppelleerstellen zu erzeugen. Es kann also ein Konzentrationsprofil vorgegeben werden.

Wenn nun hintereinander die Prozesschritte

1. Prädeposition und Eindiffusion von Ag,

2. Bestrahlung mit hochenergetischen Teilchen und

3. thermisches Aktivieren des dissoziativen Mechanismus ausgeführt werden, dann läuft in der durch die Bestrahlung erzeugten Defektzone der Prozess Ag(int) + Vac --> Ag(sub) ab, welche aufgrund der hohen Diffusivität von Ag in Silizium gegenüber dem Ausheilprozess Si(int) + Vac --> Si(sub) (diffundierende Eigenzwischengitteratome besetzen eine Leerstelle) bevorzugt ist. Das durch die Bestrahlung erzeugte Leerstellenprofil wird in ein Konzentrationsprofil von substitutionellem Ag umgewandelt.

Gegenüber den Leerstellen, wie sie bei alleiniger Anwendung von Bestrahlung erzeugt werden, ist substitutionelles Ag bezüglich Rekombination um etwa einen Faktor 10 effektiver.

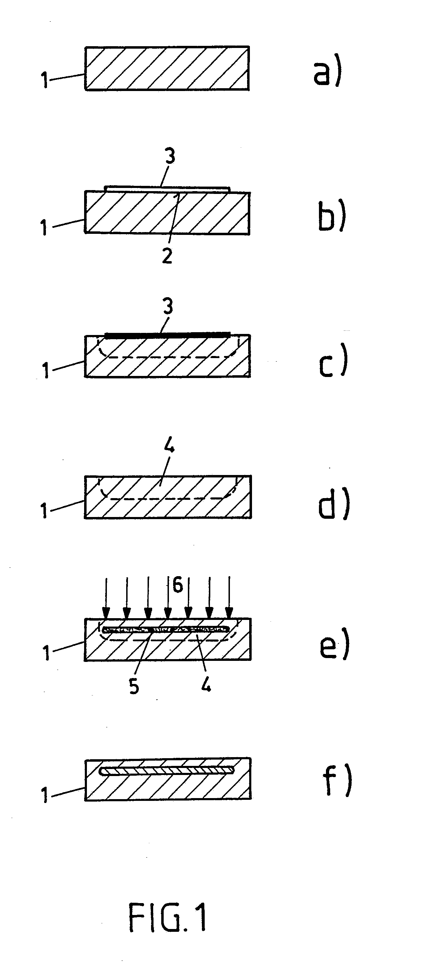

Im folgenden wird nun anhand der Figuren 1a bis 1f eine bevorzugte Ausführungsform der Erfindung erläutert. In den Figuren sind jeweils entsprechende Teile mit entsprechenden Bezugzeichen versehen.

Ausgangspunkt stellt ein Halbleitersubstrat 1 z.B. aus Silizium (Fig. 1a) nach den Diffusions- und Oxidationsprozessen (Temperatur grösser als ca. 500 °C) dar. D.h., dass beispielsweise alle Diffusionsprozesse, welche zum Herstellen eines oder mehrerer PN-Uebergänge und der dadurch bestimmten Schalteigenschaften nötig sind, abgeschlossen sind. Wenn nämlich nach den erfindungsgemässen Verfahrensschritten das Halbleitersubstrat allzustark erhitzt wird, heilen die Störstellen aus, womit auch die Lebensdauereinstellung zunichte gemacht wird.

Als erstes wird eine Vorbelegung von Fremdatomen vorgenommen (Fig. 1b). Auf einer Oberfläche 2 des Halbleitersubstrats 1 wird z.B. eine Schicht 3 aus Ag deponiert. Dies wird durch ein an sich bekanntes Verfahren wie z.B. Aufdampfen, Aufsputtern, CVD, galvanisches Abscheiden erreicht. Zum Vorbelegen eignet sich auch die Ionenimplantation, wobei die Fremdatome in einen oberflächennahen Bereich des Siliziumsubstrats eingebracht werden.

Als zweites wird ein Drive-in-Prozess durchgeführt (Fig. 1c). Die Vorbelegung bestimmt dabei die Konzentration des interstitiellen Ag und damit die in einem späteren Prozesschritt maximal erreichbare Konzentration von substitutionellem Ag. Es muss also dafür gesorgt werden, dass in einer durch die Art des Halbleiterbauelements (Diode, Thyristor, etc.) vorgegebenen Tiefe die gewünschte Konzentration von Fremdatomen entsteht.

Als drittes wird ein nach dem Drive-in-Prozess zurückgebliebener Teil der Schicht 3 entfernt (Fig. 1d). Es liegt damit ein Halbleitersubstrat 1 mit einer Zone mit interstitiellen Fremdatomen (im vorliegenden Fall Ag) vor.

Als viertes wird das Siliziumsubstrat 1 mit hochenergetischen Teilchen 6, vorzugsweise mit H+, He+, He+ + oder Neutronen, bestrahlt (Fig. 1e). Die Bestrahlung wird so ausgeführt, dass ein vorgegebenes, gewünschtes Konzentrationsprofil von Gitterstörstellen in der gewünschten Tiefe entsteht. In der Zone mit interstitiellen Fremdatomen 4 wird also eine Zone hoher Leerstellendichte 5 erzeugt. Die Bestrahlungsdosis und die Konzentration von interstitiellen Fremdatomen müssen aneinander angepasst werden, d.h. es müssen genügend Leerstellen zur Verfügung stehen.

Die Bestrahlung von Halbleitersubstraten ist als solche bekannt. Es wird deshalb an dieser Stelle nicht weiter auf diesen Verfahrensschritt eingegangen.

Schliesslich werden die interstitiellen Fremdatome thermisch aktiviert (Fig. 1f). Dieser Prozesschritt kann auf verschiedenen Arten im gesamten Herstellungsverfahren des Halbleiterbauelements integriert werden.

In einer ersten Variante erfolgt das thermische Aktivieren gleichzeitig mit dem Sintern einer Metallisierung. Die Bestrahlung wird also vor den Metallisierungsschritten ausgeführt.

In einer zweite Variante wird nach dem Entfernen der Vorbelegung und vor dem Bestrahlen mit hochenergetischen Teilchen 6 eine Metallisierung aufgebracht. Nach dem Bestrahlen wird dann eine Passivierung des Halbleiterbauelements durchgeführt, bei welcher gleichzeitig das thermische Aktivieren der Fremdatome erfolgt.

In einer dritten Variante schliesslich wird nach dem Entfernen der Vorbelegung und vor dem Bestrahlen mit hochenergetischen Teilchen 6 eine Passivierung des Halbleiterbauelements durchgeführt. Nach dem Bestrahlen erfolgt das thermische Aktivieren durch Glühen bei einer Temperatur zwischen 200 °C und 400 °C.

Die zweite und dritte Variante haben gegenüber der ersten den Vorteil, dass eine Beeinträchtigung der durchstrahlten Oberfläche vor dem Aufbringen einer Metallisierung vermieden wird. Eine primär bei höheren Bestrahlungsdosen mögliche Schädigung kann nämlich negative Auswirkungen auf die Qualität der Metallisierung haben.

Während bei den ersten beiden Varianten das thermische Aktivieren gleichzeitig mit dem Sintern der Metallisierung resp. mit dem Ausbacken der Passivierung abläuft, ist bei der dritten der zusätzliche Prozessschritt des Glühens erforderlich.

Das erfindungsgemässe Einstellen der Trägerlebensdauer beschränkt sich nicht auf einen bestimmten Typus von Halbleiterbauelementen. Es kann sowohl bei einfachen Dioden wie auch bei komplexen Thyristor-Strukturen angewendet werden.

Ebenso kann die Efindung auch bei III-V- oder II-VI-Halbleiterbauelementen eingesetzt werden

Abschliessend kann gesagt werden, dass mit der Erfindung ein Verfahren geschaffen wird, welches für einen grossen Bereich von Halbleiterbauelement-Typen zur Optimierung der Schalteigenschaften, insbesondere des trade-off zwischen Vorwärtsspannungsabfall und Schaltzeit anwendbar ist

## Ansprüche

1. Verfahren zum axialen Einstellen der Trägerlebensdauer in einem Halbleiterbauelement mit einem kristallinen Halbleitersubstrat, gekennzeichnet durch folgende Schritte:

a) Eindiffundieren von Fremdatomen in das Halbleitersubstrat, wobei die Fremdatome die Eigenschaft haben, dass sie (i) auf einem Gitterplatz rekombinationsaktiv und auf einem Zwischengitterplatz rekombinationsinaktiv sind und dass sie (ii) interstitiell und via Leerstellen-Mechanismus, aber nicht via Kick-out-Mechanismus diffundieren;

b) Bestrahlen des Halbleitersubstrats mit hochenergetischen Teilchen (6), sodass in einer vorgegebenen Tiefe ein gewünschtes Konzentrationsprofil von Gitterstörstellen entsteht;

c) thermisches Aktivieren der eindiffundierten Fremdatome.

2. Verfahren nach Anspruch 1, dadurch gekennzeichnet, dass das Halbleitersubstrat ein Siliziumsubstrat ist.

3. Verfahren nach Anspruch 1, dadurch gekennzeichnet, dass zum Eindiffundieren von Fremdatomen in das Halbleitersubstrat

a) eine Oberfläche des Halbleitersubstrats mit einer Vorbelegung von Fremdatomen versehen wird und

b) ein Drive-in-Prozess durchgeführt wird, sodass in der vorgegebenen Tiefe eine gewünschte Konzentration von Fremdatomen entsteht.

4. Verfahren nach Anspruch 3, dadurch gekennzeichnet, dass die Vorbelegung mittels Ionenimplantation erzeugt wird.

5. Verfahren nach Anspruch 3, dadurch gekennzeichnet, dass zum Eindiffundieren von Fremdatomen in das Halbleitersubstrat

a) die Vorbelegung durch Deponieren von Fremdatomen auf einer Oberfläche des Halbleitersubstrats erzeugt wird und dass

b) nach dem Drive-in-Prozess ein zurückgebliebener Teil der Vorbelegung entfernt wird.

6. Verfahren nach Anspruch 1, dadurch gekennzeichnet, dass das thermische Aktivieren gleichzeitig mit dem Sintern einer Metallisierung erfolgt.

7. Verfahren nach Anspruch 1, dadurch gekennzeichnet, dass nach dem Eindiffundieren der Fremdatome und vor dem Bestrahlen mit hochenergetischen Teilchen (6) eine Metallisierung aufgebracht wird und dass nach dem Bestrahlen eine Passivierung des Halbleiterbauelements durchgeführt wird, bei welcher gleichzeitig das thermische Aktivieren der Fremdatome erfolgt.

8. Verfahren nach Anspruch 1, dadurch gekennzeichnet, dass nach dem Eindiffundieren der Fremdatome und vor dem Bestrahlen mit hochenergetischen Teilchen (6) eine Passivierung durchgeführt wird und dass nach dem Bestrahlen das thermische Aktivieren durch Glühen bei einer Temperatur zwischen 200 °C und 400 °C erfolgt.

9. Verfahren nach Anspruch 2, dadurch gekennzeichnet, dass als Fremdatome Cu-, Ag-, oder Pd-Atome verwendet werden.

10. Verfahren nach Anspruch 1, dadurch gekennzeichnet, dass zum Bestrahlen He+, He++, Protonen oder Neutronen verwendet werden.

a)

b)

c)

d)

e)

f)

FIG.1

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | US-A-3 864 174 (AKIYAMA et al.) * Seite 3, Zeile 23 - Seite 4, Zeile 16 * | 1,2 | H 01 L 21/263 H 01 L 21/22 |
| A | US-A-4 684 413 (RCA CORP.) * Zusammenfassung * | 1,2,8, 10 | |
| A | US-A-4 177 477 (MITSUBISHI DENKI K.K.) * Seite 2, Zeile 52 - Seite 3, Zeile 43; Seite 2, Zeilen 39-42 * | 1,2,9 | |
| A | US-A-4 717 588 (MOTOROLA INC.) * Seite 2, Zeile 21, Seite 3, Zeile 47 * | 1-4,9 | |

RECHERCHIERTE
SACHGEBIETE (Int. Cl.5)

H 01 L

Der vorliegende Recherchenbericht wurde für alle Patentansprüche erstellt

| Recherchenort | Abschlußdatum der Recherche | Prüfer |
|---|---|---|
| DEN HAAG | 27-02-1990 | GELEBART J.F.M. |